# EUROPÄISCHE PATENTANMELDUNG

(11) **EP 0 608 729 A1**
(43) Veröffentlichungstag der Anmeldung: **03.08.1994**
(21) Anmeldenummer: 94100540.7
(22) Anmeldetag: 15.01.1994
(51) Int. Cl.: H01S 3/103, H01S 3/085

(54) **3-Sektions-DFB-Halbleiterlaser mit erweitertem Wellenlängen-Durchstimmungsbereich**

(30) Priorität: 23.01.1993 DE 4301830
(71) Anmelder: ANT Nachrichtentechnik GmbH, D-71522 Backnang (DE)
(72) Erfinder: Hillmer, Hartmut, Dr., D-64287 Darmstadt (DE)

(57) **Zusammenfassung**

Ein entscheidender Nachteil aller bisher bekannten 3-Sektions-DFB-Halbleiterlaser sind ihre, verglichen mit anderen Halbleiterlasern geringen Wellenlängen-Durchstimmungsbereiche. Der Erfindung liegt die Aufgabe zugrunde, einen Laser zu entwickeln, der die Vorteile von 3-Sektions-DFB-Halbleiterlasern mit einem erweiterten Wellenlängen-Durchstimmungsbereich ohne Modensprünge verbindet.

Die Aufgabe wird erfindungsgemäß durch einen 3-Sektions-DFB-Halbleiterlaser gelöst, der unterschiedliche Sektionslängen aufweist, bei dem die Lage der Phasenverschiebung außerhalb des Zentrums des Halbleiterlasers angeordnet ist und der mit mindestens ein oder zwei verschiedenen Strömen betrieben wird.

Der erfindungsgemäße Laser ermöglicht auch bei hohem Kopplungskoeffizienten eine hohe Lichtausbeute.

## Beschreibung

Die Erfindung betrifft einen 3-Sektions-DFB-Halbleiter-laser (DFB = distributed feedback), der eine größere Wellenlängen-Durchstimmbarkeit ohne Modensprünge als die bisher bekannten Ausführungen von 3-Sektions-DFB-Halb-leiterlasern ermöglicht.
Es existieren zahlreiche Veröffentlichungen über 3-Sektions-DFB-Halbleiterlaser mit identischen Sektionslängen, z. B. D. Leclerc, J. Jaquet, D. Sigogne, C. Labourie, Y.Louis, C. Artigue and J. Benoit, "Three-electrode DFB wavelength tunable FSK transmitter at 1,53µm" Electron. Lett. 25,45 (1989), und
Y. Yoshikuni and G.Motosugi, "Independent modulation in amplifier and frequency regimes by a multielectrode distributed feedback laser" Technical digest of OFC 86, pp.32-33 (1986).
Weiterhin sind symmetrische 3-Sektions-DFB-Halbleiterlaser bekannt, bei denen die äußeren beiden Sektionen identische Längen aufweisen, wie z. B. in folgenden Quellen beschrieben: Y.Kotaki and H.Ishikawa, "Wavelength tunable DFB and DBR lasers for coherent optical fibre communications", IEE Proceedings- J. 138,171 (1991), und
Y. Kotaki, S. Ogita, M. Matsuda, Y. Kuwahara and H. Ishikawa, "Tunable, narrow-linewidth and high-powerλ/4-shifted DFB-Laser" Electron. Lett. 25,990 (1989).
Die Phasenverschiebung/-en sind bei den bekannten Lösungen immer im Zentrum des Lasers, also in der Mitte der zentralen Sektion, angeordnet. Gegenüber den bekannten Bauformen durchstimmbarer Laser zeichnet sich der erfindungsgemäße Laser durch höhere Modulierbarkeit und kleinere Linienbreite aus. Ein entscheidender Nachteil aller bisher bekannten 3-Sektions-DFB-Halbleiterlaser sind ihre, verglichen mit anderen Lasern wie z. B. DBR-Laser oder TTG-Laser, geringen Wellenlängen-Durchstimmungsbereiche, die den Anwendungsbereich der 3-Sektions-DFB-Halbleiterlaser doch erheblich einschränken.
Der Erfindung liegt die Aufgabe zugrunde, einen 3-Sektions-DFB-Halbleiterlaser zu entwickeln, der die bekannten Vorteile der 3-Sektions-DFB-Halbleiterlaser mit einem erweiterten Wellenlängen-Durchstimmungsbereich ohne Modensprünge verbindet.

Die Aufgabe wird erfindungsgemäß dadurch gelöst, daß die 3 Sektionen des DFB-Halbleiterlasers so ausgebildet sind, daß sie zueinander unterschiedliche Sektionslängen aufweisen. Bei einer Gesamtlänge L des DFB-Halbleiterlasers zwischen 150 und 400 µm sind die einzelnen Sektionen im Verhältnis zueinander und im Verhältnis zur Gesamtlänge L so ausgebildet, daß die Länge der linken Sektion L_{S1} im Bereich zwischen 1/10 bis 3/10, die Länge der mittleren Sektion L_{C} im Bereich zwischen 3/10 bis 6/10 und die Länge der rechten Sektion L_{S2} im Bereich zwischen 4/10 bis 6/10 in Bezug auf die Gesamtlänge L des 3-Sektions-DFB-Halbleiterlasers liegt. Innerhalb der o. g. Längenangaben sind damit die Sektionen, entsprechend den Erfordernissen, längenmäßig zueinander variierbar, wobei aber immer gewährleistet sein muß, daß die Sektionslängen, bezüglich ihrer Längen zueinander, unsymmetrisch ausgebildet sind, die Phasenverschiebung stark aus dem Zentrum des Halbleiterlasers herausgeschoben ist und der Kopplungskoeffizient K des DFB-Gitters hoch gewählt ist. Die Trennungslücken W_{G} zwischen den Sektionen, die ebenfalls in der Gesamtlänge L enthalten sind, sind so ausgebildet, daß jeweils von Sektionslänge zu Sektionslänge ein Abstand in den Grenzen von 5 bis 10 µm gewährleistet ist. Die Nachteile eines größeren Kopplungskoeffizienten K, die insbesondere in der geringeren optischen Ausgangsleistung zum Ausdruck kommen, werden erfindungsgemäß durch eine Veränderung der Lage der Phasenverschiebung aus dem Zentrum des Halbleiterlasers heraus kompensiert. Dabei gilt, je größer der Kopplungskoeffizient, desto weiter muß die Lage der Phasenverschiebung/-en in Richtung auf die Resonator-Endfläche verschoben sein, welche in Richtung der für die Nachrichtenübertragung genutzten Streckenfaser liegt. Der minimalste Abstand der Lage der phasenverschiebung von der entsprechenden Laser-End-fläche darf jedoch keinesfalls kleiner als L/10 sein.

Die erfindungsgemäße Lösung wird anhand eines Ausführungsbeispiels näher erläutert.

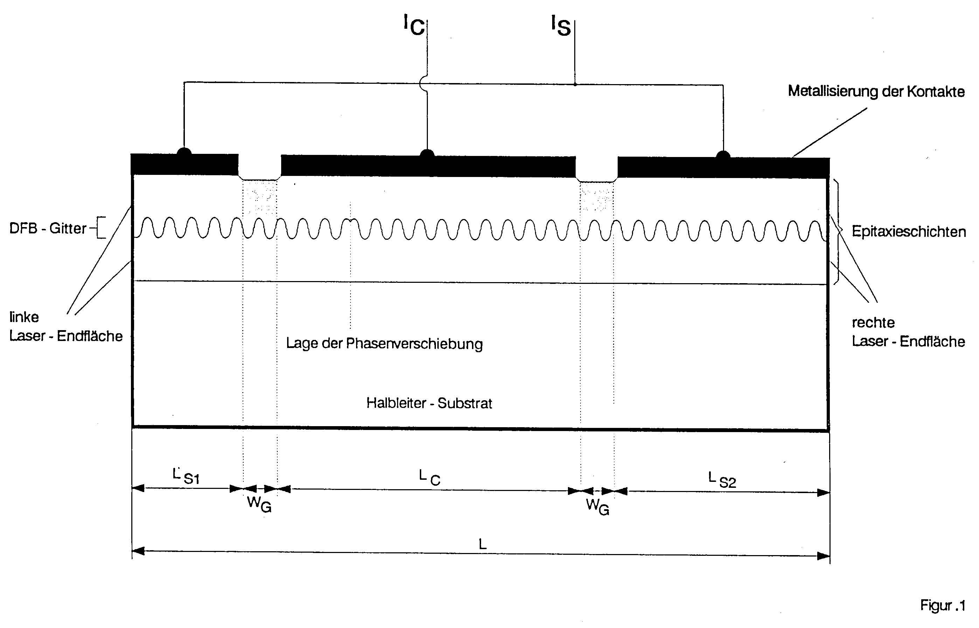

Figur 1 zeigt hierbei einen Querschnitt durch einen erfindungsgemäßen 3-Sektions-DFB-Halbleiterlaser.
In Fig.1 stellen die schwarz ausgefüllten Flächen an der Oberseite des Bauelements die Metallisierung der elektrischen Kontaktfelder dar, welche jeweils durch unterschiedliche Längen L_{S1};L_{C};L_{S2} gekennzeichnet sind und damit die individuellen Sektionslängen verdeutlichen. Die punktierten Flächen stellen die elektrische Isolierung der elektrischen Kontaktfelder voneinander dar, wobei der Isolationswiderstand 100Ω bis einige kΩ beträgt. Die elektrische Isolierung wird gewöhnlich mittels Ionenimplantation, Ätzen oder der Kombination von Ätzen und Epitaxie realisiert. Die Struktur kann sowohl auf n- wie auch auf p-Substrat basieren. Als Beispiel wurde in Fig. 1 in das DFB-Gitter unter der mittleren Sektion L_{C} eine λ4 Phasenverschiebung integriert, deren Lage durch die senkrecht gestrichelte Linie angedeutet ist. Dabei ist die Lage der Phasenverschiebung aus dem Zentrum des Halbleiterlasers immer in Richtung auf die Laser-Endfläche verschoben, welche in Richtung der für die Nachrichtenübertragung genutzten Streckenfaser liegt. Bezogen auf das in Fig. 1 dargestellte Ausführungsbeispiel ist die Lage der Phasenverschiebung in Richtung auf diejenige Laser-Endfläche verschoben, welche zur linken Sektion L_{S1} korrespondiert. Die Phasenverschiebung/-en liegt/liegen, wenn die Streckenfaser auf der linken Seite liegt, immer in der mittleren Sektion L_{C} oder in der linken Sektion L_{S1}. Die drei Sektionen werden, wie in Fig. 1 dargestellt, mit 2 verschiedenen Strömen betrieben. Die äußeren Sektionen L_{S1} und L_{S2} werden durch den Strom I_{S} elektrisch gepumpt, während die mittlere Sektion L_{C} mit dem Strom I_{C} gepumpt wird. Aus Gründen der Allgemeingültigkeit sind die einzelnen Epitaxieschichten nicht separat dargestellt. Die aktive/-n Schicht/-en können auf beiden Seiten des DFB-Gitters liegen. Die Substratunterseite ist ebenfalls metallisiert und dient als Masse-Kontakt (in Fig. 1 nicht dargestellt). Noch größere Durchstimmungsbereiche werden dadurch erreicht, daß alle drei Sektionen L_{S1};L_{C};L_{S2} mit verschiedenen Strömen betrieben werden. Als Grenzfall ist auch eine kurze ungepumpte oder schwach gepumpte Rand-Sektion denkbar.
Die Wellenlängendurchstimmung kann bei dem Bauelement bei Verwendung von ein oder zwei Steuerströmen folgendermaßen erfolgen:
- der Strom I_{S} oder I_{C} ist fixiert und der andere Strom I_{C} oder I_{S} wird variiert,
- beide Ströme werden abhängig voneinander durch ein Netzwerk bestimmt, welches mit einem einzelnen Steuerstrom betrieben wird, oder
- der Gesamtstrom I_{C} + I_{S} ist fixiert und das Teilungsverhältnis zwischen I_{C} und I_{S} wird variiert, z. B. mittels eines einzigen Steuerstroms über ein Netzwerk.
Große Kopplungskoeffizienten verursachen bekanntlich am Ort der Phasenverschiebung/-en sowohl eine starke PhotonenfeldÜberhöhung als auch damit gekoppelt, eine starke Ladungsträgerdichte-Reduktion (räumliches Lochbrennen). Durch optimierte Geometrieparameter der Struktur und geeignete Variation der Steuerströme I_{C} und I_{S} kann die Schwell-Verstärkung (threshold gain modulation) und die durch räumliches Lochbrennen induzierte Verstärkung des Plasmaeffektes auf die Emissionswellenlängen-Änderung des Bauelements beträchtlich verstärkt werden. Bei der Nutzung des räumlichen Lochbrennens erweist sich eine λ/4-Phasenverschiebung günstiger als im Vergleich dazu zwei λ/8 Phasenverschiebungen. Diese verstärkte elektronische Wellenlängen-Durchstimmung ist besonders für schnelle Emissions-Wellenlängen-Änderungen über größere Wellenlängen-Bereiche interessant. Dieser Effekt läßt sich insbesondere durch die erfindungsgemäße Bauform des 3-Sektions-DFB-Halbleiterla-sers herauspräparieren. Durch Optimierung kann dieser Effekt verstärkt und gezielt zur Vergrößerung des Wellenlängen-Durchstimmungsbereiches eingesetzt werden.

Im folgenden werden einige konkrete Anwendungsbeispiele für die erfindungsgemäße Konfiguration beschrieben.
Zur Erhöhung der einseitigen externen Quantenausbeute wird eine Veränderung der Lage der Phasenverschiebung in Richtung einer Laser-Endfläche (Laser-Facette) vorgenommen, und zwar so, daß die gesammte Resonatorlänge im Verhältnis 3:7 geteilt ist. Durch diese Asymmetrie kann der Kopplungskoeffizient sehr groß gewählt werden (z. B. K>80cm⁻¹; L-200-300 m). An der Facette, die näher an der Phasenverschiebung liegt (Frontfacette), ist nun die externe Quantenausbeute auf Kosten der rückwärtigen Facette wesentlich vergrößert.Zur Erhöhung der Braggmoden-Stabilität erfolgt die Berechnung der longitudinalen Photonenverteilungen derjenigen beiden Seitenmoden, welche dem Schwellengain der Braggmode am nächsten kommen. Die Wahl der Sektionslängen erfolgt z. B. nach folgendem Schema: Linke Sektionstrennung an der Stelle, an welcher der Mittelpunkt der beiden Intensitätsmaxima der betrachteten Seitenmoden auf der linken Seite liegt. Rechte Sektionstrennung an der Stelle, an welcher der Mittelpunkt der beiden Intensitätsmaxima der betrachteten Seitenmoden auf der rechten Seite liegt. Der Kopplungskoeffizient, der relativ hoch gewählt wird (K>80cm⁻¹), wirkt dabei stabilisierend.
Zur Vergrößerung des Wellenlängen-Durchstimmungsbereichs müssen große Kopplungskoeffizienten (K>80 cm⁻¹;L-200-300 m) verwendet werden, wenn das räumliche Lochbrennen verstärkend für die Wellenlängen-Durchstimmung genutzt werden soll.
Ein Beispiel dafür wird anhand eines 3-Sektions-DFB-Halbleiterlasers näher erläutert. Bei dieser Ausführungsform liegt die Phasenverschiebung in der mittleren Sektion L_{C} bei 70µm, gemessen von der linken Resonator-Endfläche. Die Länge der rechten Sektion L_{S2} liegt bei 149 µm. Die Länge der linken Sektion L_{S1} liegt bei 41 µm. Die Länge der mittleren Sektion L_{C} liegt bei 100µm. Der Abstand zwischen den einzelnen Sektionen W_{G} liegt bei 5µm. Die Gesamtlänge L des erfindungsgemäßen Bauelements liegt bei 300 µm.
Bei einem weiteren Ausführungsbeispiel für eine Bauelementelänge von L = 200 µm liegt die Länge der linken Sektion L_{S1} bei 20µm, die Länge der mittleren Sektion L_{C} bei 80 µm und die Länge der rechten Sektion L_{S2} bei 90µm. Der Abstand zwischen den einzelnen Sektionen W_{G} liegt bei 5µm und der Abstand der Phasenverschiebung liegt, gemessen von der linken Resonator Endfläche aus, bei 60 µm.
Bei diesen Beispielen handelt es sich um mögliche Ausführungsformen. Die optimalen Kombinationen der Laserparameter werden rechnerisch ermittelt, z. B. mit Hilfe eines Transfer-matrix-Modells oder eines Coupled-Mode Modells. Die Art, Größe und Verteilung der Phasenverschiebung/-en wird in diesen rechnerischen Optimierungsverfahren ebenfalls festgelegt. In die Verfahren können noch weitere Parameter einbezogen werden, wie z. B. die Variation in longitudinaler Richtung der DFB-Gitterperiode Λ (z) und des Kopplungskoeffizienten K(z). Die Optimierung erfolgt je nach der erwünschten Anwendung entweder im Hinblick auf die Verstärkung elektronischer Wellenlängen-Durchstimmungs Effekte für ultra-schnelle Wellenlängendurchstimmung über weite Wellenlängen-Differenzen, oder im Hinblick auf die simultane Ausnutzung von thermischen und elektronischen WellenlängenDurchstimmungs Effekten zur Erzielung eines möglichst großen Gesamt-Wellenlängen-Durchstimmungsbereichs. Der nutzbare Durchstimmungsbereich ist in herkömmlichen 3-Sektions-DFB-Halbleiterlasern vielfach auch durch Reduktion der Seitenmoden-Unterdrückung eingeschränkt. Dies kann durch ein zusätzlich stabilisierendes Element der Einmodigkeit erreicht werden, indem eine kurze, schwach oder ungepumpte Seiten-Sektion, nur durch einen kleinen Separationswiderstand von der mittleren Sektion getrennt wird, wobei der Separationswiderstand und die betreffende Sektionslänge rechnerisch optimiert werden.
Die Vorteile der erfindungsgemäßen Lösung liegen insbesondere darin begründet, daß die Struktur des erfindungsgemäßen Bauelements verhältnismäßig einfach ist, da es mit nur ein oder zwei Steuerströmen betrieben werden kann, wobei eine größere Wellenlängen-Durchstimmbarkeit ohne Modensprünge als bei den bekannten 3-Sektions-DFB-Halbleiter-lasern, welche mit vergleichbaren Steuerströmen betrieben werden, erreicht wird. Die größere Durchstimmbarkeit beruht auf der geometrischen Asymmetrie in Bezug auf die unterschiedlichen Sektionslängen, auf dem hohen Kopplungskoeffizienten K, sowie auf der asymmetrischen Lage der Phasenverschiebung/-en außerhalb der Mitte des Halbleiterlasers. Damit ist es möglich, unter Beibehaltung der bekannten Vorteile der 3-Sektions-DFB-Halbleiterlaser, wie der sehr geringen Linienbreite und der sehr schnellen Modulierbarkeit, trotz hoher Kopplungskoeffizienten eine hohe Lichtausbeute zu realisieren. Durch die erfindungsgemäße Lösung erfährt der durchstimmbare 3-Sektions-DFB-Halbleiterlaser, bezüglich seines Anwendungsbereichs, eine beträchtliche Aufwertung gegenüber dem durchstimmbaren DBR-Laser.

## Patentansprüche

1. 3-Sektions-DFB-Halbleiterlaser mit erweitertem Wellenlängen-Durchstimmungsbereich, **dadurch gekennzeichnet**, daß seine Gesamtlänge (L) zwischen 150 und 400µm beträgt, und daß seine einzelnen Sektionen (L_{S1};L_{C};L_{S2}) unterschiedlich lang sind, wobei im Verhältnis zur Gesamtlänge (L) der Längenanteil der linken Sektion (L_{S1}) zwischen 1/10 bis 3/10, der Längenanteil der mittleren Sektion (L_{C}) zwischen 3/10 bis 6/10 und der Längenanteil der rechten Sektion (L_{S2}) zwischen 4/10 bis 6/10 der Gesamtlänge (L) variierbar ist, daß die Trennungslücken (W_{G}), die in die Gesamtlänge (L) einbezogen sind, zwischen den einzelnen Sektionen einen Abstand von 5 bis 10µm aufweisen, daß die drei Sektionen (L_{S1};L_{C};L_{S2}) vorzugsweise mit zwei verschiedenen Strömen (I_{C};I_{S}) betrieben werden, daß das Produkt aus Gesamtlänge (L) und Kopplungskoeffizient (K) zwischen 2 und 4 beträgt, daß die Lage der Phasenverschiebung aus dem Zentrum des Halbleiterlasers in Richtung auf die Laser-Endfläche verschoben ist, die in Richtung der für die Nachrichtenübertragung genutzten Streckenfaser liegt, wobei dies diejenige Laser-Endfläche ist, welche zur linken Sektion L_{S1} korrespondiert, und daß der minimalste Abstand der Lage der Phasenverschiebung von der entsprechenden Laser-Endfläche nicht kleiner als L/10 ist.

2. 3-Sektions-DFB-Halbleiterlaser nach Anspruch 1, dadurch gekennzeichnet, daß bei Vertauschung der Längenanteile der linken Sektion L_{S1} mit den Längenanteilen der rechten Sektion L_{S2} die Lage der Phasenverschiebung in Richtung auf die Laser-Endfläche verschoben ist, die zur rechten Sektion L_{S2} korrespondiert.
